# EUROPÄISCHE PATENTANMELDUNG

(11) **EP 2 521 264 A1**
(43) Veröffentlichungstag der Anmeldung: **07.11.2012**
(21) Anmeldenummer: 12166333.0
(22) Anmeldetag: 02.05.2012
(51) Int. Cl.: H03K 17/96

(54) **Kapazitive Bedieneinrichtung für ein Haushaltsgerät und Verfahren zum Betreiben einer kapazitiven Bedieneinrichtung in einem Haushaltsgerät**

(30) Priorität: 02.05.2011 DE 102011075083
(71) Anmelder: BSH Bosch und Siemens Hausgeräte GmbH, 81739 München (DE)
(72) Erfinder: Helmschmidt, Holger, 93049 Regensburg (DE); Schmid, Erich, 93173 Wenzenbach (DE)

(57) **Zusammenfassung**

Es soll die Empfindlichkeit einer kapazitiven Bedieneinrichtung für ein Haushaltsgerät im Vergleich zum Stand der Technik erhöht werden. Eine erfindungsgemäße Bedieneinrichtung (100) beinhaltet eine Sensorelektrode (113) als Teil eines Berührungskondensators (114) mit durch Berührung veränderbarer Kapazität. Ein Signalgeber (101) gibt an seinem Signalausgang (102) ein Taktsignal (103) aus. Ein erster Anschluss (104) eines Transistors (105) ist mit dem Signalausgang (102) gekoppelt, während ein Steuereingang (111) des Transistors (105) mit dem Signalausgang (102) und mit der Sensorelektrode (113) gekoppelt ist. Ein Kondensator (110, 122) ist zwischen einem zweiten Anschluss (106) des Transistors (105) und einem Bezugspotential (109) geschaltet. Eine Auswerteeinheit (108) wertet die Amplitude einer am Kondensator (110, 122) anliegenden Spannung (U1, U2) aus. Es sind Mittel (123) zum Entkoppeln des zweiten Anschlusses (106) des Transistors (105) von dem Kondensator (110, 122) bereitgestellt, um ein Entladen des Kondensators (110, 122) über ein parasitäres Element des Transistors (105) zu verhindern.

## Beschreibung

Die Erfindung betrifft eine kapazitive Bedieneinrichtung für ein Haushaltsgerät. Die Bedieneinrichtung beinhaltet eine Sensorelektrode, welche ein Bestandteil eines Berührungskondensators mit durch Berührung veränderbarer Kapazität ist - der Finger der Bedienperson stellt hier die zweite Kondensatorplatte dar. Die Bedieneinrichtung umfasst auch einen Signalgeber, welcher ein Taktsignal an einem Signalausgang ausgibt. Ein erster Anschluss eines Transistors ist mit dem Signalausgang des Signalgebers gekoppelt; ein Steuereingang des Transistors ist mit dem Signalausgang des Signalgebers und darüber hinaus auch mit der Sensorelektrode gekoppelt. Zwischen einem zweiten Anschluss des Transistors und einem Bezugspotential ist ein Kondensator geschaltet. Mit dem Kondensator ist eine Auswerteeinheit gekoppelt, welche zum Auswerten der Amplitude einer an dem Kondensator anliegenden elektrischen Spannung dient. Die Erfindung betrifft außerdem ein Haushaltsgerät mit einer derartigen Bedieneinrichtung, wie auch ein Verfahren zum Betreiben einer kapazitiven Bedieneinrichtung in einem Haushaltsgerät.

Kapazitive Bedieneinrichtungen sind bereits aus dem Stand der Technik in vielfältiger Ausgestaltung bekannt. So ist aus der Druckschrift EP 0 780 981 B1 eine Auswerteelektronik für das Ausgangssignal eines auf Berührung ansprechenden Sensorelements bekannt, welche den Signalpegel des Ausgangssignals erfasst und mit einem Schwellwert vergleicht. In der Auswerteelektronik sind eine Vielzahl von unterschiedlich hohen Schwellwerten für den Signalpegel und diesen zugeordnete verschieden lange Zeitfenster vorgegeben. Die Auswerteelektronik gibt ein Schaltsignal aus, wenn der jeweilige Signalpegel des Ausgangssignals einen der Schwellwerte erreicht und während des diesem zugeordneten Zeitfensters vorlag, wobei höheren Schwellwerten kürzere Zeitfenster und niedrigeren Schwellwerten längere Zeitfenster zugeordnet sind.

Weiterhin beschreibt die Druckschrift EP 1 777 821 B1 eine elektronische Schaltungsanordnung für ein Haushaltsgerät, welche zur Feststellung einer Kapazitätsabweichung dient. Die Schaltungsanordnung kann eine differenzierte Kapazitätsabweichung auf zwei unterschiedlichen Kondensatoren mit jeweils unterschiedlichen Kapazitäten feststellen.

Kapazitive Bedieneinrichtungen sind außerdem aus den Dokumenten EP 1 562 292 A1 sowie DE 43 40 481 C1 bekannt.

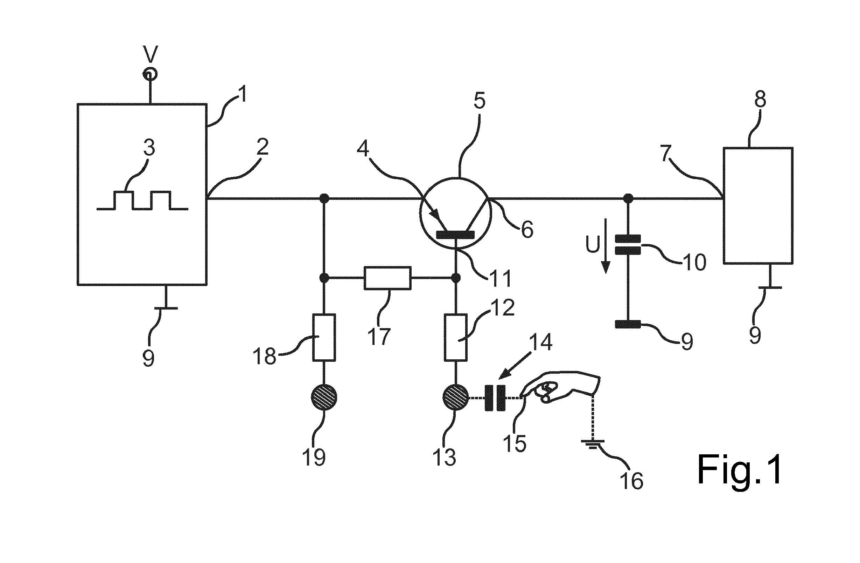

Die Erfindung geht von einer kapazitiven Bedieneinrichtung aus, wie sie im Dokument DE 10 2005 041 113 A1 beschrieben und in der vorliegenden Fig. 1 dargestellt ist: Ein Signalgeber 1 stellt an seinem Signalausgang 2 ein Taktsignal 3 bereit, welches ein Rechtecksignal mit einer Frequenz von 10 kHz bis 100 kHz ist. Der Signalausgang 2 ist mit einem Emitter-Anschluss 4 eines PNP-Bipolartransistors 5 direkt verbunden. Ein Kollektor-Anschluss 6 des Bipolartransistors 5 ist mit einem analogen Messeingang 7 einer Auswerteeinheit 8 direkt verbunden. Zwischen dem Messeingang 7 und einem Bezugspotential 9 (Masse) ist ein Kondensator 10 geschaltet, an welchem eine elektrische Spannung U anliegt. Mit einem Basis-Anschluss 11 des Bipolartransistors 5 ist über einen Ohmschen Widerstand 12 eine Sensorelektrode 13 gekoppelt, welche ein Teil eines mit 14 schematisch angedeuteten Berührungskondensators mit durch Annäherung bzw. Berührung veränderlicher Kapazität ist. Der Berührungskondensator 14 ist einerseits durch die Sensorelektrode 13 und andererseits auch durch einen Finger 15 einer Bedienperson gebildet, welche das elektrische Potential 16 der Erde führt. Zwischen dem Finger 15 und der Sensorelektrode 13 befindet sich eine in Fig. 1 nicht dargestellte Bedienblende aus Kunststoff (Dielektrikum). Der Basis-Anschluss 11 ist außerdem über einen weiteren Ohmschen Widerstand 17 mit dem Signalausgang 2 des Signalgebers 1 gekoppelt. Der Widerstand 17 bzw. der Signalausgang 2 ist außerdem über einen Ohmschen Widerstand 18 mit einer Abschirmung 19 gekoppelt.

Weil das Taktsignal 3 ein Rechtecksignal ist, sind am Signalausgang 2 und somit am Emitter-Anschluss 4 im Prinzip zwei verschiedene Zustände möglich: An den Signalausgang 2 wird abwechselnd das Bezugspotential 9 ("Low"-Pegel) und eine Versorgungsspannung V (z.B. 8V) des Signalgebers 1 ("High"-Pegel) angelegt. Findet keine Berührung statt, so ist das elektrische Potential am Basis-Anschluss 11 im Wesentlichen gleich dem elektrischen Potential am Emitter-Anschluss 4, und der Bipolartransistor 5 sperrt, nämlich aufgrund einer zu geringen Spannung zwischen dem Basis-Anschluss 11 und dem Emitter-Anschluss 4. Berührt nun die Bedienperson die Bedienblende des Haushaltsgeräts, so wird der Berührungskondensator 14 gebildet, und es fließt elektrische Ladung durch den Berührungskondensator 14. Nun steigt die Spannung zwischen dem Emitter-Anschluss 4 und dem Basis-Anschluss 11, sodass der Bipolartransistor 5 leitend geschaltet wird. Die Amplitude der Spannung U am Kondensator 10 steigt an, was durch die Auswerteeinheit 8 als eine Berührung und somit als ein Bedienen ausgewertet wird. Dabei misst die Auswerteeinheit 8 den absoluten Pegel der Spannung U. Wird ein Schwellwert der Amplitude innerhalb einer vorbestimmten Zeitdauer relativ rasch erreicht, so wird dies als eine Berührung ausgewertet.

Es ist Aufgabe der Erfindung, eine Lösung aufzuzeigen, wie die Empfindlichkeit einer kapazitiven Bedieneinrichtung der eingangs genannten Gattung im Vergleich zum Stand der Technik, insbesondere im Vergleich zum Gegenstand gemäß Druckschrift DE 10 2005 041 113 A1, erhöht werden kann.

Diese Aufgabe wird erfindungsgemäß durch eine kapazitive Bedieneinrichtung mit den Merkmalen gemäß Patentanspruch 1, durch ein Haushaltsgerät mit den Merkmalen gemäß Patentanspruch 8 sowie durch ein Verfahren mit den Merkmalen gemäß Patentanspruch 9 gelöst. Vorteilhafte Ausführungen der Erfindung sind Gegenstand der abhängigen Patentansprüche, der Beschreibung und der Figuren.

Eine erfindungsgemäße kapazitive Bedieneinrichtung für ein Haushaltsgerät beinhaltet eine Sensorelektrode als Teil eines Berührungskondensators mit durch Berührung veränderbarer Kapazität. Sie umfasst auch einen Signalgeber, welcher ein Taktsignal an seinem Signalausgang bereitstellen kann. Ein erster Anschluss eines Transistors ist mit dem Signalausgang des Signalgebers gekoppelt, während ein Steuereingang des Transistors mit dem Signalausgang des Signalgebers und mit der Sensorelektrode gekoppelt ist. Ein Kondensator ist zwischen einem zweiten Anschluss des Transistors und einem Bezugspotential geschaltet. Eine mit dem Kondensator gekoppelte Auswerteeinheit ist zum Auswerten der Amplitude einer an dem Kondensator anliegenden elektrischen Spannung ausgebildet. Erfindungsgemäß sind Mittel bereitgestellt, welche den zweiten Anschluss des Transistors von dem Kondensator entkoppeln, um ein Entladen des Kondensators über ein parasitäres Element des Transistors - etwa über eine parasitäre Diode - im elektrisch sperrenden Schaltzustand des Transistors zu verhindern.

Der Erfindung liegen mehrere Erkenntnisse zugrunde: Die Erfindung beruht zunächst auf der Erkenntnis, dass die kapazitiven Bedieneinrichtungen aus dem Stand der Technik (Fig. 1) eine relativ geringe Empfindlichkeit aufweisen - so verändert sich bei einer Verwirklichung der Bedieneinrichtung gemäß Fig. 1 die Amplitude der am Kondensator 10 anliegenden Spannung U beim Berühren der Bedienblende lediglich um etwa 10% (etwa von 2,5 V auf 2,75 V). Eine weitere Erkenntnis besteht darin, dass im Stand der Technik die geringe Empfindlichkeit der Bedieneinrichtung dadurch verursacht wird, dass sich der Berührungskondensator 14 nicht vollständig entladen kann bzw. sich die positive Ladung an dem Basis-Anschluss 11 nicht vollständig abbauen kann. Die Erfindung basiert ferner auf der Erkenntnis, dass im Stand der Technik die vollständige Entladung des Berührungskondensators 14 deshalb nicht möglich ist, weil sich der Kondensator 10 über die Basis-Kollektor-Strecke des Transistors 5 - nämlich über die parasitäre Diode und aufgrund des Miller-Effekts - sowie über den Widerstand 17 entlädt und somit stets eine positive Ladung am Basis-Anschluss 11 bzw. im Berührungskondensator 14 vorhanden ist. Der Erfindung liegt schließlich die Erkenntnis zugrunde, dass die Nachteile des Stands der Technik dadurch umgangen und die vollständige Entladung des Berührungskondensators 14 bzw. das vollständige Abbauen der positiven Ladung am Basis-Anschluss 11 dadurch ermöglicht werden können, dass ein Stromfluss vom Kondensator 10 hin zum Transistor 5 verhindert wird, und zwar durch Einsatz entsprechender Mittel, die zum Entkoppeln des Transistors von dem Kondensator ausgebildet sind. Auf diese Weise wird der Stromfluss vom Kondensator über die Basis-Kollektor-Strecke des Transistors hin zu dem Signalgeber verhindert, und der Berührungskondensator 14 kann sich über den Signalgeber vollständig entladen, nämlich beim Vorliegen des "Low"-Pegels des Taktsignals, also wenn das Signalausgang des Signalgebers auf Masse gelegt wird. Auf diesem Wege gelingt es, einen möglichst großen Hub des Signalpegels bei der Berührung der Bedienblende zu erzielen, also eine möglichst große Änderung der Amplitude der am Kondensator anliegenden elektrischen Spannung. Somit kann die Empfindlichkeit der Bedieneinrichtung auf ein Maximum gebracht werden, und es können fehlerhafte Detektionen verhindert werden.

Somit ergeben sich auch eine Vielzahl von weiteren Vorteilen: Aufgrund der erhöhten Empfindlichkeit sind neue Anwendungsmöglichkeiten der Bedieneinrichtung gegeben, weil kleinere Sensorflächen auf der Bedienblende möglich sind. Es muss insbesondere kein Leitlack oder anderes leitendes Material auf der Außenseite der Bedienblende aufgebracht werden. Es können außerdem dickere Bedienblenden eingesetzt werden bzw. der Abstand zwischen der Sensorelektrode und der Außenoberfläche der Bedienblende kann vergrößert werden. Auch die Auswertung der Amplitude der am Kondensator anliegenden Spannung ist einfacher als im Stand der Technik. Die Änderung der Amplitude bei Berühren der Bedienblende ist nämlich so groß, dass auch ein Störsignal bzw. Rauschen eine fehlerhafte Auswertung der Amplitude nicht verursachen kann. Nicht zuletzt ist die Verwendung eines Materials für die Bedienblende mit schlechteren dielektrischen Eigenschaften als im Stand der Technik möglich.

Unter einem Haushaltsgerät wird vorliegend ein Gerät verstanden, welches zur Haushaltsführung eingesetzt wird. Das Haushaltsgerät ist also ein Gerät, welches zur Behandlung von Haushaltsgegenständen (etwa Wäschestücke und/oder Geschirr und/oder Lebensmittel und dergleichen) ausgebildet ist. Es kann ein Haushaltsgroßgerät sein, wie beispielsweise eine Waschmaschine, ein Wäschetrockner, eine Geschirrspülmaschine, ein Gargerät, eine Dunstabzugshaube, ein Kältegerät, eine Kühl-Gefrier-Kombination oder ein Klimagerät. Es kann aber auch ein Haushaltskleingerät sein, wie beispielsweise ein Kaffeevollautomat oder eine Küchenmaschine.

Es erweist sich als besonders vorteilhaft, wenn die Mittel zum Entkoppeln eine Diode beinhalten, nämlich insbesondere eine einfache PN-Diode. Die Kathode der Diode kann mit dem Kondensator gekoppelt sein, während ihre Anode mit dem zweiten Anschluss des Transistors gekoppelt sein kann. Auf diese Weise kann ein Stromfluss vom Kondensator hin zum Transistor besonders zuverlässig verhindert werden, ohne dass teure und/oder aktive Bauelemente eingesetzt werden müssen. Es kann außerdem der wertvolle Bauraum gespart werden, weil die Diode ein besonders kompaktes Bauelement ist.

Bevorzugt weist die Diode eine Schaltzeit (auch unter der Bezeichnung "Sperrverzögerungszeit" oder "Sperr-Erholzeit" bzw. "reverse recovery time" bekannt) auf, die kleiner als 100 ns, insbesondere kleiner als 50 ns, noch bevorzugter kleiner als 10 ns, ist. Vorzugsweise wird eine Diode eingesetzt, deren Schaltzeit kleiner als 5 ns ist, insbesondere 4 ns beträgt. Somit ist die Schaltzeit der Diode deutlich geringer als eine halbe Periodendauer des Taktsignals. Auf diese Weise wird der Stromfluss vom Kondensator hin zum Transistor annähernd vollständig verhindert, und der Berührungskondensator kann besonders rasch entladen werden.

Die Diode kann auch eine Kapazität (so genannte Null-Kapazität bzw. Kapazität zwischen dem PN-Übergang) aufweisen, die kleiner als 50 pF, insbesondere kleiner als 20 pF, noch bevorzugter kleiner als 10 pF, ist. Die Kapazität der Diode kann sogar kleiner als 5 pF sein; sie kann beispielsweise 1,5 pF betragen. Somit kann der Stromfluss vom Kondensator hin zum Transistor auf ein Minimum gedrosselt werden.

Also verhindern die Mittel zum Entkoppeln des Transistors vom Kondensator einen Stromfluss vom Kondensator hin zum Transistor. Um dennoch eine Entladung des Kondensators zu ermöglichen, sind in einer Ausführungsform Entlademittel bereitgestellt, über welche der Kondensator unter Umgehung des Transistors zumindest teilweise im Betrieb entladen wird. Somit kann die Spannung am Kondensator variieren, und es wird ein ordnungsgemäßer Betrieb der Bedieneinrichtung ermöglicht.

Bevorzugt umfassen die Entlademittel einen parallel zum Kondensator geschalteten Entladewiderstand, über welchen der Kondensator zumindest teilweise im Betrieb entladen werden kann. Diese Ausführungsform ist besonders einfach zu realisieren; es braucht lediglich ein Widerstand parallel zum Kondensator eingesetzt zu werden, und der Kondensator kann im Betrieb über den Widerstand entladen werden. Wie die Diode ist auch ein Ohmscher Widerstand ein besonders kompaktes Bauelement, sodass der wertvolle Bauraum gespart wird. Mit diesen Bauelementen können auch bereits vorhandene Bedieneinrichtung nachgerüstet werden.

Der Transistor ist vorzugsweise ein PNP-Bipolartransistor, dessen Emitter mit dem Signalausgang des Signalgebers und dessen Kollektor mit der Auswerteeinheit gekoppelt sind. Somit wird ermöglicht, dass beim Berühren der Bedienblende der Transistor leitend geschaltet wird und sich die Amplitude der am Kondensator anliegenden Spannung verändert.

Ein erfindungsgemäßes Haushaltsgerät beinhaltet eine erfindungsgemäße kapazitive Bedieneinrichtung.

Ein erfindungsgemäßes Verfahren ist zum Betreiben einer kapazitiven Bedieneinrichtung in einem Haushaltsgerät ausgelegt. Es wird ein Taktsignal an einem Signalausgang eines Signalgebers bereitgestellt, und das Taktsignal wird an einen ersten Anschluss eines Transistors sowie an einen Steuereingang des Transistors abgegeben. Die Kapazität eines eine Sensorelektrode - welche mit dem Steuereingang des Transistors gekoppelt ist - aufweisenden Berührungskondensators wird beim Berühren durch eine Bedienperson verändert. Somit wird der Transistor in einen elektrisch leitenden Schaltzustand geschaltet. Es wird ein Kondensator aufgeladen, der zwischen einem zweiten Anschluss des Transistors und einem Bezugspotential geschaltet ist. Eine mit dem Kondensator gekoppelte Auswerteeinheit wertet die Amplitude einer am Kondensator anliegenden elektrischen Spannung aus. Der zweite Anschluss des Transistors wird von dem Kondensator entkoppelt, um ein Entladen des Kondensators über ein parasitäres Element des Transistors zu verhindern.

Die mit Bezug auf die erfindungsgemäße Bedieneinrichtung vorgestellten bevorzugten Ausführungsformen und deren Vorteile gelten entsprechend für das erfindungsgemäße Haushaltsgerät sowie für das erfindungsgemäße Verfahren.

Weitere Merkmale der Erfindung ergeben sich aus den Ansprüchen, den Figuren und der Figurenbeschreibung. Alle vorstehend in der Beschreibung genannten Merkmale und Merkmalskombinationen sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen oder aber in Alleinstellung verwendbar.

Die Erfindung wird nun anhand eines bevorzugten Ausführungsbeispiels, wie auch unter Bezugnahme auf die beigefügten Zeichnungen, näher erläutert.

Es zeigen:
- Fig. 1: in schematischer Darstellung eine kapazitive Bedieneinrichtung gemäß dem Stand der Technik; und
- Fig. 2: eine kapazitive Bedieneinrichtung gemäß einer Ausführungsform der Erfindung.

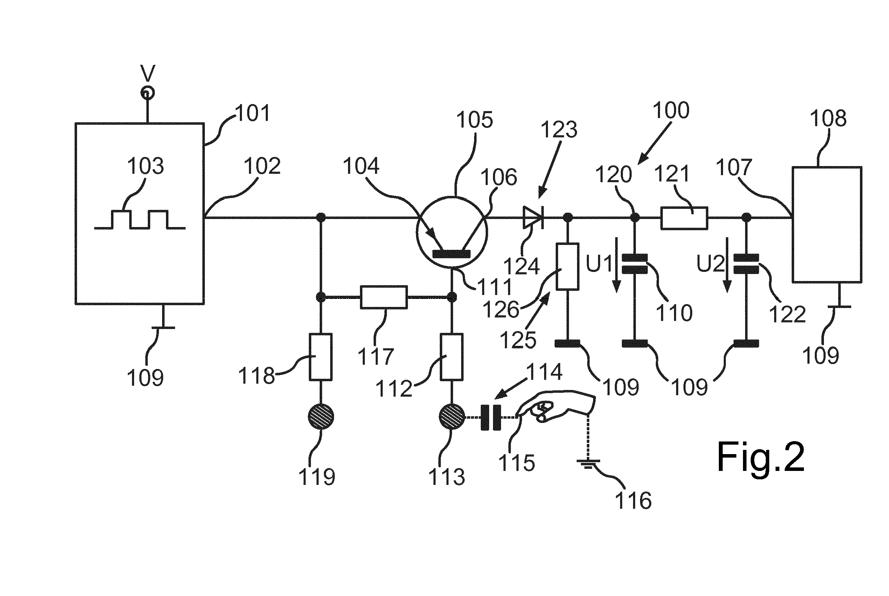

In Fig. 2 ist eine kapazitive Bedieneinrichtung 100 dargestellt, welche in einem Haushaltsgerät eingesetzt wird. Die Bedieneinrichtung 100 beinhaltet einen Signalgeber 101, welcher an seinem Signalausgang 102 ein Taktsignal 103 ausgeben kann. Das Taktsignal 103 ist ein Rechtecksignal mit einer Frequenz aus einem Wertebereich von 10 kHz bis 100 kHz. Das Taktsignal 103 hat also zwei verschiedene Zustände, nämlich einen "Low"-Pegel - hier wird der Signalausgang 102 mit einem Bezugspotential 109 (Masse) verbunden - sowie einen "High"-Pegel - hier liegt am Signalausgang 102 eine Versorgungsspannung V des Signalgebers 101 an. Der Signalausgang 102 ist mit einem ersten Anschluss 104 eines Transistors 105 direkt verbunden. Der Transistor 105 ist ein PNP-Bipolartransistor, und der erste Anschluss 104 ist der Emitter. Ein zweiter Anschluss 106 des Transistors 105 - also der Kollektor - ist mit einem analogen Messeingang 107 einer Auswerteeinheit 108 gekoppelt. Die Auswerteeinheit 108 kann ein Mikrocontroller sein. Sie kann ein vom Signalgeber 101 separates Bauteil sein. Alternativ kann der Signalgeber 101 in die Auswerteeinheit 108 integriert sein.

Ein Steuereingang 111 des Transistors 105 - also seine Basis - ist über einen Ohmschen Widerstand 112 mit einer Sensorelektrode 113 elektrisch gekoppelt. Die Sensorelektrode 113 kann beispielsweise an der Rückseite einer Bedienblende des Haushaltsgeräts angebracht sein. Die Sensorelektrode 113 bildet zusammen mit einem Finger 115 der Bedienperson einen Berührungskondensator 114. Bei Annäherung des Fingers 115 an die Bedienblende bzw. bei Berührung der Bedienblende verändert sich die Kapazität des Berührungskondensators 114, weil die Bedienperson das elektrische Potential 116 der Erde führt.

Der Steuereingang 111 ist des Weiteren über einen Ohmschen Widerstand 117 mit dem Signalausgang 102 des Signalgebers 101 gekoppelt. Der Signalausgang 102 ist auch über einen Ohmschen Widerstand 118 mit einer Abschirmung 119 elektrisch gekoppelt.

Der zweite Anschluss 106 des Transistors 105 ist mit dem Messeingang 107 über einen Schaltungsknoten 120 gekoppelt. Zwischen dem Schaltungsknoten 120 und dem Bezugspotential 109 ist ein Kondensator 110 geschaltet. Der Schaltungsknoten 120 ist außerdem über einen Ohmschen Widerstand 121 mit dem Messeingang 107 gekoppelt. Zwischen dem Messeingang 107 und dem Bezugspotential 109 ist außerdem ein weiterer Kondensator 122 geschaltet, welcher zusammen mit dem Widerstand 121 ein RC-Filter bildet, mittels welchem eine am Kondensator 110 anliegende Spannung U1 gefiltert - hier geglättet - wird. Am Kondensator 122 liegt dann eine elektrische Spannung U2 an. Die Amplitude der Spannung U2 wird am Messeingang 107 erfasst und durch die Auswerteeinheit 108 ausgewertet.

Die Bedieneinrichtung 100 beinhaltet auch Mittel 123 zum Entkoppeln des Kondensators 110 und des Kondensators 122 vom zweiten Anschluss 106 des Transistors 105. Die Mittel 123 umfassen im Ausführungsbeispiel eine Diode 124, deren Kathode mit dem Schaltungsknoten 120 und deren Anode mit dem zweiten Anschluss 106 direkt verbunden sind. Es wird beispielsweise eine Diode 124 eingesetzt, welche eine Kapazität von 1,5 pF sowie eine Schaltzeit von 4ns aufweist. Im Ausführungsbeispiel bestehen die Mittel 123 ausschließlich aus der Diode 124.

Die Bedieneinrichtung 100 beinhaltet auch Entlademittel 125, über welche die Kondensatoren 110 und 122 im Betrieb teilweise entladen werden können. Die Entlademittel 125 umfassen einen Entladewiderstand 126, welcher parallel zum Kondensator 110 bzw. zwischen dem Schaltungsknoten 120 und dem Bezugspotential 109 geschaltet ist. Im Ausführungsbeispiel bestehen die Entlademittel 125 ausschließlich aus dem Widerstand 126.

Also liegt an dem ersten Anschluss 104 des Transistors 105 abwechselnd der "Low"-Pegel und der "High"-Pegel des Taktsignals 103 an. Auch am Steuereingang 111 liegt das Taktsignal 103 an, nämlich über den Widerstand 117. Ohne den Finger 115 ist somit die elektrische Spannung zwischen dem ersten Anschluss 104 und dem Steueranschluss 111 (Basis-Emitter-Spannung) zu gering, um den Transistor 105 leitend zu schalten. Ohne den Finger 115 befindet sich somit der Transistor 105 in seinem elektrisch sperrenden Schaltzustand. Wird nun die Bedienblende mit dem Finger 115 berührt, so fließt durch den Berührungskondensator 114 elektrische Ladung. Während am ersten Anschluss 104 der "High"-Pegel anliegt, liegt der Steuereingang 111 im Wesentlichen an dem elektrischen Potential 116 der Erde, sodass der Transistor 105 durchschaltet. Bei einem "Low"-Pegel am Signalausgang 102 ist der erste Anschluss 104 hingegen mit dem Bezugspotential 109 verbunden, und der Transistor 105 sperrt. Beim "Low"-Pegel des Taktsignals 103 kann sich der Berührungskondensator 114 über die Widerstände 112 und 117 sowie über den Signalgeber 101 entladen, ohne dass dieser Entladevorgang durch einen Stromfluss aus den Kondensatoren 110 und 122 verhindert wird. Diese können nämlich über den Widerstand 126 entladen werden, da die Diode 124 den Stromfluss zum Transistor 105 verhindert. Somit kann der Berührungskondensator 114 vollständig entladen werden, sodass die Empfindlichkeit der Bedieneinrichtung 100 im Vergleich zum Stand der Technik deutlich verbessert wird.

Der Widerstandswert des Widerstands 126 kann beispielsweise in einem Wertebereich von 1 kΩ bis 100 kΩ liegen. Im Ausführungsbeispiel kann er beispielsweise 10 kΩ oder 22 kΩ betragen.

Vergleicht man nun die Bedieneinrichtung 100 gemäß Fig. 2 mit der Bedieneinrichtung gemäß Fig. 1 (Stand der Technik), so ergibt sich bei derselben Dimensionierung der gemeinsamen Bauteile folgende Empfindlichkeitssteigerung: Während bei der Bedieneinrichtung gemäß Fig. 1 sich die Amplitude der Spannung U beim Berühren von etwa 2,5 V auf etwa 2,75 V, also um etwa 10%, verändert, erhöht sich die Amplitude der Spannung U2 bei der Bedieneinrichtung 100 gemäß Fig. 2 von 1,25 V auf etwa 2V, also um 60%. Die Empfindlichkeit der Bedieneinrichtung 100 wird somit im Vergleich zum Stand der Technik wesentlich erhöht.

### Bezugszeichenliste

- 1: Signalgeber
- 2: Signalausgang
- 3: Taktsignal
- 4: Emitteranschluss
- 5: PNP-Bipolartransistor
- 6: Kollektoranschluss
- 7: analoger Messeingang
- 8: Auswerteeinheit
- 9: Bezugspotential
- 10: Kondensator
- 11: Basis-Anschluss
- 12: Ohmscher Widerstand
- 13: Sensorelektrode
- 14: Berührungskondensator
- 15: Finger
- 16: elektrisches Potential der Erde
- 17: Ohmscher Widerstand
- 18: Ohmscher Widerstand
- 19: Abschirmung
- 100: kapazitive Bedieneinrichtung
- 101: Signalgeber
- 102: Signalausgang
- 103: Taktsignal
- 104: erster Anschluss
- 105: Transistor
- 106: zweiter Anschluss
- 107: analoger Messeingang
- 108: Auswerteeinheit
- 109: Bezugspotential
- 110: Kondensator
- 111: Steuereingang
- 112: Ohmscher Widerstand
- 113: Sensorelektrode
- 114: Berührungskondensator
- 115: Finger
- 116: elektrisches Potential der Erde
- 117: Ohmscher Widerstand
- 118: Ohmscher Widerstand
- 119: Abschirmung
- 120: Schaltungsknoten
- 121: Ohmscher Widerstand
- 122: Kondensator
- 123: Entkopplungsmittel
- 124: Diode
- 125: Entlademittel
- 126: Entladewiderstand
- U: elektrische Spannung
- U1: elektrische Spannung
- U2: elektrische Spannung
- V: Versorgungsspannung

## Patentansprüche

1. Kapazitive Bedieneinrichtung (100) für ein Haushaltsgerät, mit:
- einer Sensorelektrode (113) als Teil eines Berührungskondensators (114) mit durch Berührung veränderbarer Kapazität,
- einem Signalgeber (101), welcher dazu ausgelegt ist, an einem Signalausgang (102) ein Taktsignal (103) auszugeben,
- einem Transistor (105), dessen erster Anschluss (104) mit dem Signalausgang (102) des Signalgebers (101) gekoppelt ist und dessen Steuereingang (111) mit dem Signalausgang (102) des Signalgebers (101) und mit der Sensorelektrode (113) gekoppelt ist,
- einem Kondensator (110, 122), der zwischen einem zweiten Anschluss (106) des Transistors (105) und einem Bezugspotential geschaltet ist, und
- einer mit dem Kondensator (110, 122) gekoppelten Auswerteeinheit (108) zum Auswerten der Amplitude einer an dem Kondensator (110, 122) anliegenden elektrischen Spannung (U1, U2),
**gekennzeichnet durch**
Mittel (123) zum Entkoppeln des zweiten Anschlusses (106) des Transistors (105) von dem Kondensator (110, 122), um ein Entladen des Kondensators (110, 122) über ein parasitäres Element des Transistors (105) zu verhindern.

2. Kapazitive Bedieneinrichtung (100) nach Anspruch 1, **dadurch gekennzeichnet, dass** die Mittel (123) zum Entkoppeln eine Diode (124) umfassen, deren Kathode mit dem Kondensator (110, 122) und deren Anode mit dem zweiten Anschluss (106) des Transistors (105) gekoppelt sind.

3. Kapazitive Bedieneinrichtung (100) nach Anspruch 2, **dadurch gekennzeichnet, dass** die Diode (124) eine Schaltzeit kleiner als 100 ns, insbesondere kleiner als 50 ns, noch bevorzugter kleiner als 10 ns, aufweist.

4. Kapazitive Bedieneinrichtung (100) nach Anspruch 2 oder 3, **dadurch gekennzeichnet, dass** die Diode (124) eine Kapazität kleiner als 50 pF, insbesondere kleiner als 20 pF, noch bevorzugter kleiner als 10 pF, aufweist.

5. Kapazitive Bedieneinrichtung (100) nach einem der vorhergehenden Ansprüche, **gekennzeichnet durch** Entlademittel (125), über welche der Kondensator (110, 122) unter Umgehung des Transistors (105) zumindest teilweise im Betrieb entladen wird.

6. Kapazitive Bedieneinrichtung (100) nach Anspruch 5, **dadurch gekennzeichnet, dass** die Entlademittel (125) einen parallel zum Kondensator (110, 122) geschalteten Entladewiderstand (126) umfassen, über welchen der Kondensator (110, 122) zumindest teilweise im Betrieb entladen wird.

7. Kapazitive Bedieneinrichtung (100) nach einem der vorhergehenden Ansprüche, **dadurch gekennzeichnet, dass** der Transistor (105) ein PNP-Bipolartransistor ist, dessen Emitter mit dem Signalausgang (102) des Signalgebers (101) und dessen Kollektor mit der Auswerteeinheit (108) gekoppelt sind.

8. Haushaltsgerät mit einer kapazitiven Bedieneinrichtung (100) nach einem der vorhergehenden Ansprüche.

9. Verfahren zum Betreiben einer kapazitiven Bedieneinrichtung (100) in einem Haushaltsgerät durch
- Bereitstellen eins Taktsignals (103) an einem Signalausgang (102) eines Signalgebers (101) und Abgeben des Taktsignals (103) an einen ersten Anschluss (104) eines Transistors (105) sowie an einen Steuereingang (111) des Transistors (105),
- Verändern einer Kapazität eines eine Sensorelektrode (113), die mit dem Steuereingang (111) des Transistors (105) gekoppelt ist, aufweisenden Berührungskondensators (114) beim Berühren durch eine Bedienperson und hierdurch Schalten des Transistors (105) in einen elektrisch leitenden Schaltzustand,
- Aufladen eines Kondensators (110, 122), der zwischen einem zweiten Anschluss (106) des Transistors (105) und einem Bezugspotential geschaltet ist, und
- Auswerten der Amplitude einer an dem Kondensator (110, 122) anliegenden elektrischen Spannung (U1, U2) durch eine mit dem Kondensator (110, 122) gekoppelten Auswerteeinheit (108), **gekennzeichnet durch**
- Entkoppeln des zweiten Anschlusses (106) des Transistors (105) von dem Kondensator (110, 122), um ein Entladen des Kondensators (110, 122) über ein parasitäres Element des Transistors (105) zu verhindern.
